# EUROPÄISCHE PATENTSCHRIFT

(11) **EP 4 435 932 B1**
(45) Veröffentlichungstag und Bekanntmachung des Hinweises auf die Patenterteilung: **03.06.2026**
(21) Anmeldenummer: 23163255.5
(22) Anmeldetag: 21.03.2023
(51) Int. Cl.: H01M 10/615, H01M 10/6571, H01M 50/503, H01M 50/505, H01M 50/524

(54) **KONTAKTIERUNGSPLATINE**
CONTACTING BOARD
PLATINE DE CONTACT

(43) Veröffentlichungstag der Anmeldung: 25.09.2024
(73) Patentinhaber: HOPPECKE Systemtechnik GmbH, 08056 Zwickau (DE)
(72) Erfinder: RICHTER, SIMON, 08304 SCHÖNHEIDE (DE); REINHOLD, STEFAN, 08058 ZWICKAU (DE); TRAPP, MAGNUS, 33181 BAD WÜNNENBERG (DE)
(74) Vertreter: Brinkmann & Partner

(56) Entgegenhaltungen:
- EP-A1- 3 739 670
- EP-A1- 3 961 792
- DE-A1- 102015 010 925
- US-A1- 2020 036 064

## Beschreibung

Die Erfindung betrifft eine Kontaktierungsplatine für ein Energiespeichermodul, insbesondere für einen Lithium-Ionen-Akkumulator, mit einem flexiblen Kunststoffsubstrat, das erste Leiterbahnen für eine elektrische Verbindung einer Sensorplatine mit Anschlusspolen des Energiespeichermoduls bereitstellt, wobei das Kunststoffsubstrat eine erste Großseite und eine hierzu parallel ausgerichtete, zweite Großseite aufweist, wobei eine der beiden Großseiten mit einer Heizeinrichtung ausgerüstet ist. Die Erfindung betrifft des Weiteren ein Energiespeichermodul, insbesondere einen Lithium-Ionen-Akkumulator, der eine Mehrzahl von miteinander elektrisch verschalteten Lithium-Ionen-Zellen aufweist, wobei das Energiespeichermodul mit einer Kontaktierungsplatine ausgerüstet ist.

Aus dem Stand der Technik ist gemäß der DE 10 2015 010 925 A1 eine Zellverbindereinheit und/oder Zellspannungsabgriffseinheit bekannt. Diese Einheit verfügt über einen Grundkörper, der auch als Platine bezeichnet und aus Kunststoff gebildet sein kann. Dieser Grundkörper ist mit einer Temperiereinheit ausgerüstet, die elektrisch ausgebildet sein kann, und zwar in der Ausgestaltung einer Heizeinrichtung. Dabei kann als Heizeinrichtung ein mäanderförmig verlaufender Widerstandsdraht vorgesehen sein.

Des Weiteren ist aus dem Stand der Technik gemäß der US 2020/036064 A1 ein Batteriemodul mit mehreren Batteriezellen bekannt, wobei die Zellenanschlüsse der Batteriezellen über Stromschienen miteinander verbunden sind. Diese Stromschienen sind durch Heizgruppen abgedeckt, wobei jede Heizgruppe ein wärmeleitendes Pad aufweist. Ein jedes Pad steht mit einer Wärmeleitverteilplatte in Kontakt, wobei an den Wärmeleitverteilplatten Heizelemente angebracht sind.

Eine Kontaktierungsplatine der eingangs genannten, d. h. gattungsgemäßen Art ist aus der EP 3 715 171 B1 bekannt.

Die aus der EP 3 715 171 B1 bekannte Kontaktierungsplatine verfügt über ein flexibles Kunststoffsubstrat. Dieses ist bspw. nach Art einer Folie ausgebildet.

Das Kunststoffsubstrat weist erste Leiterbahnen auf, die im endmontierten Zustand dazu dienen, eine Sensorplatine mit Anschlusspolen des Energiespeichermoduls zu verbinden. Zu diesem Zweck verfügt die Kontaktierungsplatine über Kontaktierungselemente, die im endmontierten Zustand mit den Anschlusspolen des Energiespeichermoduls elektrisch verbunden sind.

Die ersten Leiterbahnen, die das Kunststoffsubstrat aufweist, sind einendseitig an die mit den Anschlusspolen des Energiespeichermoduls zusammenwirkenden Kontaktierungselemente und anderendseitig an eine Sensorplatine elektrisch angeschlossen, sodass eine elektrisch leitende Verbindung zwischen der Sensorplatine und den Anschlusspolen des Energiespeichermoduls ausgebildet ist. Dabei kann die Sensorplatine als separate Platine oder als Komponente der Kontaktierungsplatine ausgebildet sein.

Die Sensorplatine verfügt über eine elektronische Schaltung, die dazu eingerichtet ist, Spannungsmessungen auszuwerten.

Das Energiespeichermodul verfügt über eine Mehrzahl von miteinander elektrisch verschalteten Zellen. Dabei weist jede Zelle zwei Anschlusspole auf, und zwar einen negativen Anschlusspol einerseits und einen positiven Anschlusspol andererseits. Zwecks Spannungsmessung sind die einzelnen Zellen des Energiespeichermoduls mit der Sensorplatine elektrisch verbunden, zu welchem Zweck die Kontaktierungsplatine in schon vorbeschriebener Weise dient.

Von der Sensorplatine erfasste Spannungswerte können mittels der von der Sensorplatine bereitgestellten elektronischen Schaltung ausgewertet werden, wobei es auch möglich ist, Spannungswerte einzelner Zellen des Energiespeichermoduls miteinander vergleichen zu können. So lässt sich insbesondere auch der Ladezustand ermitteln, und zwar nicht nur des Energiespeichermoduls als solches, sondern auch der einzelner Zellen.

Im endmontierten Zustand ist die Kontaktierungsplatine in Höhenrichtung des Energiespeichermoduls von oben auf dieses aufgesetzt, wobei eine Lagefixierung der Kontaktierungsplatine dadurch erfolgt, dass die Kontaktierungselemente der Kontaktierungsplatine mit den zugehörigen Anschlusspolen des Energiespeichermoduls verbunden, bspw. verlötet oder verschweißt sind. Ferner kann die Kontaktierungsplatine zusätzlich mit der Oberseite des Energiespeichermoduls bzw. mit der Oberseite der Zellen des Energiespeichermoduls verklebt oder sonst wie verbunden sein.

Obgleich sich die aus der EP 3 715 171 B1 vorbekannte Kontaktierungsplatine im alltäglichen Praxiseinsatz bewährt hat, besteht Verbesserungsbedarf, insbesondere mit Blick auf ein erweitertes Anwendungsspektrum. Es ist deshalb die **Aufgabe** der Erfindung, eine Kontaktierungsplatine der eingangs genannten Art konstruktiv dahingehend weiterzuentwickeln, dass bei einer gleichzeitigen Performanzsteigerung ein erweitertes Anwendungsspektrum erreicht ist.

Zur **Lösung** dieser Aufgabe wird mit der Erfindung eine Kontaktierungsplatine der gattungsgemäßen Art vorgeschlagen, die sich dadurch auszeichnet, dass das Kunststoffsubstrat auf seiner dem Energiespeichermodul im endmontierten Zustand abgewandten Seite mit einer dritten und einen Balancing-Widerstand bereitstellenden Leiterbahn ausgerüstet ist.

Das Kunststoffsubstrat, das bspw. als flexible Kunststofffolie ausgebildet ist, verfügt über zwei Großseiten, die zueinander parallel verlaufend ausgerichtet sind. Einer dieser beiden Seiten ist im endmontierten Zustand dem Energiespeichermodul zugewandt. Die dieser Seite gegenüberliegende andere Seite des Kunststoffsubstrats ist indes im endmontierten Zustand vom Speichermodul abgewandt.

Es ist vorgesehen, dass das Kunststoffsubstrat eine Heizeinrichtung aufweist, und zwar ist eine der beiden Großseiten mit einer Heizeinrichtung ausgerüstet. Dabei ist es bevorzugt, dass die dem Energiespeichermodul im endmontierten Zustand zugewandte Seite des Kunststoffsubstrats die Heizeinrichtung aufweist.

Die Kontaktierungsplatine stellt im Ergebnis zwei Funktionalitäten bereit. Zum einen sind in herkömmlicher Weise erste Leiterbahnen gegeben, die in Entsprechung des Standes der Technik einer elektrischen Verbindung einer Sensorplatine mit Anschlusspolen des Energiespeichermoduls dienen. Zum anderen ist die Kontaktierungsplatine mit einer Heizeinrichtung ausgestattet, die es im Bedarfsfall ermöglicht, das Energiespeichermodul bzw. die Zellen des Energiespeichermoduls mit Wärme zu beaufschlagen. Um einen möglichst direkten Wärmeübergang von der Heizeinrichtung auf das Energiespeichermodul bzw. auf die vom Energiespeichermodul bereitgestellten Zellen zu ermöglichen, ist die Heizeinrichtung vorzugsweise auf der Seite des Kunststoffsubstrats angeordnet, die im endmontierten Zustand dem Energiespeichermodul zugewandt ist. Die Heizeinrichtung kann aber auch alternativ auf der Seite des Kunststoffsubstrats angeordnet sein, die im endmontierten Zustand dem Energiespeichermodul abgewandt ist. In diesem Fall wirkt das Kunststoffsubstrat der Kontaktierungsplatine zwar in nachteiliger Weise wärmeisolierend, doch ob der nur sehr dünnen Ausgestaltung des Kunststoffsubstrats, beispielsweise als flexible Kunststofffolie, stellt sich im bestimmungsgemäßen Verwendungsfall eine nur geringfügige Verschlechterung des Wärmeübergangs ein. Von Vorteil der Anordnung der Heizeinrichtung auf der im endmontierten Zustand dem Energiespeichermodul abgewandten Großseite des Kunststoffsubstrats ist indes, dass während einer Montage und/oder im Wartungsfall direkt, d. h. ohne weitere Hilfsmittel durch visuelle Inaugenscheinnahme die bestimmungsgemäße und korrekte Ausrichtung der Heizeinrichtung in Relation zu den einzelnen vom Energiespeichermodul bereitgestellten Zellen ermöglicht ist.

Technologiebedingt ist nicht bei allen Energiespeichermodulen, insbesondere Lithium-Ionen-Akkumulatoren ein Laden bei niedrigen Temperaturen möglich. Die Kontaktierungsplatine schafft hier Abhilfe, da durch einen bedarfsgerechten und wahlweisen Betrieb der von der Kontaktierungsplatine bereitgestellten Heizeinrichtung eine vorgebbare Temperatur für die einzelnen Zellen des Energiespeichermoduls erreichbar ist, die ein optimiertes Laden der Zellen ermöglicht. Auf den Einsatz von aus dem Stand der Technik bekannten separaten Heizfolien kann so verzichtet werden. Die ohnehin vorgesehene Kontaktierungsplatine dient in Ihrer Ausgestaltung als Heizfolienersatz, da sie die zusätzliche Funktionalität der Heizeinrichtung mit bereitstellt. Die Kontaktierungsplatine verfügt somit über ein erweitertes Anwendungsspektrum, da sie nicht nur der elektrischen Verbindung einer Sensorplatine mit Anschlusspolen des Energiespeichermoduls dient, sondern darüber hinaus auch die Möglichkeit bietet, das Energiespeichermodul bzw. die davon bereitgestellten Zellen im Bedarfsfall erwärmen zu können.

Die Integration einer Heizeinrichtung in eine Kontaktierungsplatine ist besonders kostengünstig, da es keiner zusätzlichen Heizeinrichtung bspw. in der Ausgestaltung einer Heizfolie bedarf und auch weitere zusätzliche Bauteile nicht benötigt werden. Die endfertige Ausgestaltung eines Energiespeichermoduls unter Verwendung einer Kontaktierungsplatine erweist sich deshalb sowohl in der Herstellung als auch in der Montage im Vergleich zum Stand der Technik als einfacher und damit auch kostengünstiger.

Die Anordnung der Heizeinrichtung auf der Kontaktierungsplatine erbringt zudem den Vorteil, dass die Heizeinrichtung in einfacher Weise an das Energiespeichermodul elektrisch angeschlossen werden kann, sodass im bestimmungsgemäßen Betriebsfall die Heizeinrichtung aus der Gesamtspannung des Energiespeichermoduls versorgt wird. Alternativ kann natürlich auch eine externe Energieversorgung für die Heizeinrichtung vorgesehen werden. Von Vorteil ist aber der elektrische Anschluss der Heizeinrichtung an das Energiespeichermodul, da es hierfür keiner zusätzlichen Bauteile und/oder Montageschritte während der Herstellung bedarf.

Insgesamt wird mit der Kontaktierungsplatine eine Platine bereitgestellt, die multifunktional ist, indem sie einerseits im bestimmungsgemäßen Verwendungsfall für eine ordnungsgemäße elektrische Verbindung zwischen einer Sensorplatine und den Anschlusspolen des Energiespeichers sorgt, andererseits aber auch eine Heizeinrichtung zur Verfügung stellt, die im Bedarfsfall eine Erwärmung des Energiespeichermoduls auf eine Temperatur ermöglicht, die einen optimierten Ladevorgang unterstützt bzw. gewährleistet.

Erfindungsgemäß ist vorgesehen, dass das Kunststoffsubstrat auf einer seiner beiden Großseiten mit einer dritten und einen Balancing-Widerstand bereitstellenden Leiterbahn ausgerüstet ist. Gemäß dieser Ausführungsform verfügt die Kontaktierungsplatine über eine dritte Leiterbahn. Diese stellt wenigstens einen Balancing-Widerstand bereit. Bevorzugterweise sind mehrere solcher Balancing-Widerstände vorgesehen, und zwar jeweils ein Widerstand pro Parallelverbund. Dabei ist die Leiterbahn auf einer der beiden Großseiten des Kunststoffsubstrats ausgebildet. Es ist in diesem Zusammenhang indes bevorzugt, dass die Großseite des Kunststoffsubstrats mit der dritten Leiterbahn ausgerüstet ist, die dem Energiespeichermodul im endmontierten Zustand abgewandt ist. Demnach ist die Heizeinrichtung von einer ersten Großseite des Kunststoffsubstrats bereitgestellt, wohingegen die dritte Leiterbahn auf der anderen der beiden Großseiten des Kunststoffsubstrats ausgebildet ist. Alternativ können sowohl die dritte Leiterbahn als auch die Heizeinrichtung von ein und derselben Großseite des Kunststoffsubstrats bereitgestellt sein. Insbesondere aus Platzgründen ist es aber bevorzugt, beide Großseiten des Kunststoffsubstrats gleichermaßen zur Unterbringung der einzelnen Leiterbahnen zu verwenden, weshalb es auch aus Gründen der vereinfachten Herstellung erwünscht ist, auf einer der beiden Großseiten des Kunststoffsubstrats die Heizeinrichtung und auf der anderen der beiden Großseiten sowohl die erste als auch die dritte Leiterbahn unterzubringen.

Das passive Balancing dient beim Aufladen des Energiespeichermoduls dazu, sämtliche Zellen des Energiespeichermoduls gleich aufzuladen. Dabei arbeitet das passive Balancing nur im Bereich des Ladeschlusses, also wenn die Zellen des Energiespeichermoduls fast vollständig geladen sind. Zu jeder Zelle, die bereits die Ladeschlussspannung erreicht hat, wird durch das Balancing ein Balancing-Widerstand parallelgeschaltet, was eine Begrenzung der Spannung auf die Ladeschlussspannung bewirkt. Im Weiteren wird dann diese Zelle nur noch geringfügig weitergeladen oder sogar geringfügig entladen, während die anderen Zellen, die die Ladeschlussspannung noch nicht erreicht haben, weiterhin die volle Versorgung mit Ladestrom erhalten. Die Leistung des Parallelwiderstandes ist dabei an den Ladestrom angepasst, da die überschüssige Energie in Form von Wärme am Widerstand auftritt. Von Vorteil dieser Balancing-Methode ist im Besonderen, dass sie kostengünstig und technisch einfach realisierbar ist.

Nach dem Stand der Technik sind die Balancing-Widerstände für ein passives Balancing auf einer dafür vorgesehenen Platine eines Batteriemanagementsystems untergebracht. Von Nachteil dieser vorbekannten Anordnung ist, dass das thermische Management nur geringe Balancingströme zulässt. Ferner sind unterschiedliche Spannungslagen der Zellchemien NMC (Lithium-Nickel-Mangan-Kobalt), LFP (Lithium-Eisenphosphat) und LTO (Lithium-Titanoxid) bei der Widerstandsauslegung in einem modularen Batteriemanagementsystem ein großer Nachteil.

Die nun erfindungsgemäß vorgesehene Unterbringung der Balancing-Widerstände nicht auf einer Batteriemanagementsystem-Platine, sondern auf einer flexiblen Kontaktierungsplatine überwindet diese Nachteile. Durch die hohe Wärmekapazität der Zellen des Energiespeichermoduls ist eine gute Wärmeabfuhr gewährleistet, was deutlich größere Balancingströme ermöglicht. Ferner ist aufgrund der Anordnung der Balancing-Widerstände auf der flexiblen Kontaktierungsplatine eine Widerstandsauslegung an die Spannungslagen der Zellen möglich. Daraus folgt eine deutliche Performanzsteigerung des passiven Balancings.

Gemäß einem weiteren Merkmal der Erfindung ist vorgesehen, dass die dritte Leiterbahn an die ersten Leiterbahnen elektrisch angeschlossen ist. Es ist so eine direkte elektrische Kopplung der ersten Leiterbahnen mit der einen Balancing-Widerstand bereitstellenden dritten Leiterbahn gegeben. Es ist so im Ergebnis ein einfacher Aufbau der Kontaktierungsplatine gegeben, der es auch ermöglicht, sämtliche Leiterbahnen in einfacher Weise durch Drucken auf dem flexiblen Kunststoffsubstrat der Kontaktierungsplatine aufzubringen.

Wie schon vorstehend ausgeführt, ist es gemäß einem weiteren Merkmal der Erfindung bevorzugt, dass es die dem Energiespeichermodul im endmontierten Zustand abgewandte Seite des Kunststoffsubstrats ist, die mit der dritten Leiterbahn und/oder den ersten Leiterbahnen ausgerüstet ist. Dementsprechend ist die Heizeinrichtung bzw. die von der Heizeinrichtung bereitgestellte zweite Leiterbahn auf der dem Energiespeichermodul im endmontierten Zustand zugewandten Seite des Kunststoffsubstrats angeordnet.

Gemäß einem weiteren Merkmal der Erfindung ist vorgesehen, dass die Heizeinrichtung einer auf das Kunststoffsubstrat aufgebrachte, vorzugsweise aufgedruckte zweite Leiterbahn aus Kupfer aufweist.

Die Heizeinrichtung ist als quasi Heizwendel ausgebildet, die aus einer auf das Kunststoffsubstrat aufgebrachten Leiterbahn gebildet ist. Die Leiterbahn besteht aus vorzugsweise Kupfer und ist auf das Kunststoffsubstrat bspw. aufgedruckt. Es ist so im Ergebnis eine Kontaktierungsplatine gegebenen, die über ein Kunststoffsubstrat als Trägermaterial verfügt, das auf einer ersten Seite mit ersten Leiterbahnen und auf einer zweiten Seite mit zweiten Leiterbahnen ausgerüstet ist. Dabei dienen die ersten Leiterbahnen in schon vorbeschriebener Weise der elektrischen Verbindung einer Sensorplatine mit Anschlusspolen des Energiespeichermoduls, wohingegen die zweiten Leiterbahnen als Heizwendel die erfindungsgemäße Heizeinrichtung bilden. Die Ausgestaltung der Heizeinrichtung erweist sich als besonders einfach und kostengünstig. Insbesondere gestattet es diese Ausführungsform, in einem Arbeitsschritt eine Kontaktierungsplatine auszubilden, die in ihrer Funktionalität auch die der Heizeinrichtung mit bereitstellt.

Gemäß einem weiteren Merkmal der Erfindung ist vorgesehen, dass die zweite Leiterbahn zumindest abschnittsweise mäanderförmig verlaufend ausgebildet ist. Werden so kompakte Heizwiderstände ausgebildet, die dank ihrer Anordnung auf dem Kunststoffsubstrat der Kontaktierungsplatine im endmontierten Zustand lagesicher direkt oberhalb einer zugehörigen Zelle des Energiespeichermoduls zu liegen kommen. Es ist so eine insgesamt kompakte Heizeinrichtung ausgebildet, die darüber hinaus in vorteilhafter Weise eine positionsgenaue Zuordnung zu den einzelnen Zellen des Energiespeichermoduls ermöglicht.

In diesem Zusammenhang wird gemäß einem weiteren Merkmal der Erfindung vorgeschlagen, dass das Kunststoffsubstrat eine geometrische Ausgestaltung aufweist, die der Zellenanordnung innerhalb des Energiespeichermoduls entspricht. So kann bspw. insbesondere eine leiterförmige Ausgestaltung des Kunststoffsubstrats vorgesehen sein, wobei das Kunststoffsubstrat Streifenabschnitte aufweist, die im endmontierten Zustand direkt oberhalb einer Zelle des Energiespeichermoduls zu liegen kommen. Diese Streifenabschnitte weisen auf ihrer der jeweiligen Zelle zugewandten Unterseite die mäanderförmig verlaufenden zweiten Leiterbahnen der erfindungsgemäßen Heizeinrichtung auf. Es ist so eine direkte Zuordnung zwischen den zweiten Leiterbahnen der Heizeinrichtung und der jeweiligen Zelle des Energiespeichermoduls positionsgenau sichergestellt.

Gemäß einem weiteren Merkmal der Erfindung ist vorgesehen, dass die zweite Leiterbahn an das Energiespeichermodul elektrisch anschließbar ausgebildet ist. Es ist hierdurch in vorteilhafter Weise ermöglicht, die Heizeirichtung aus der Gesamtspannung des Energiespeichermoduls versorgen zu können. Konstruktiv kann dies bspw. dadurch umgesetzt sein, dass die zweiten Leiterbahnen in Kontakte münden, die wiederum ihrerseits im bestimmungsgemäßen Verwendungsfall mit Anschlusspolen des Energiespeichermoduls elektrisch verbunden sind.

Gemäß einem weiteren Merkmal der Erfindung ist vorgesehen, dass die Kontaktierungsplatine Temperatursensoren trägt. Diese sind mittels entsprechender Leiterbahnen mit der Sensorplatine gekoppelt, sodass mittels der elektronischen Schaltung der Sensorplatine eine Auswertung der von den Temperatursensoren im bestimmungsgemäßen Verwendungsfall gelieferten Zellen-Temperaturmessungen vorgenommen werden kann. Dabei kann eine Auswertung der erfassten Zellentemperaturen nicht nur dazu dienen, eine Zelltemperaturüberwachung durchzuführen, sondern auch dazu, die Heizeinrichtung zu regeln, insbesondere können die erfassten Temperaturwerte dazu dienen, zu Beginn eines Ladevorgangs zu bestimmen, ob für einen optimierten Ladevorgang die Heizeinrichtung einzuschalten ist oder nicht. Darüber hinaus ist natürlich auch eine automatisierte Abschaltung der Heizeinrichtung ermöglicht, wenn die für einen optimierten Ladevorgang nötige Zellentemperatur erreicht ist.

Gemäß einem weiteren Merkmal der Erfindung sind mit den Anschlusspolen des Energiespeichers zusammenwirkende Kontaktierungselemente vorgesehen, die zum Kunststoffsubstrat beabstandet ausgebildet sind. Die Kontaktierungselemente sind mithin nicht vom flexiblen Kunststoffsubstrat der Kontaktierungsplatine bereitgestellt. Dies erbringt im Unterschied zum Stand der Technik einen sehr viel weniger filigranen Aufbau der Kontaktierungsplatine, was insbesondere mit Bezug auf eine Montage der Kontaktierungsplatine von Vorteil ist, insbesondere deshalb, weil eine automatisierte Anordnung der Kontaktierungsplatine auf einem Energiespeichermodul sehr viel einfacher realisierbar ist.

Die Kontaktierungselemente - auch Zellabgriff genannt - werden vorzugsweise in einem Herstellungsschritt mit den zugehörigen Leiterbahnen ausgebildet. Auch eine zu den Leiterbahnen separate Ausgestaltung der Kontaktierungselemente ist natürlich denkbar. Entscheidend ist indes allein, dass die Kontaktierungselemente nicht vom Kunststoffsubstrat der Kontaktierungsplatine getragen sind. Die Kontaktierungselemente sind vielmehr beabstandet zum Kunststoffsubstrat ausgebildet, dem Kunststoffsubstrat im endfertig montierten Zustand also nebengeordnet. Für eine elektrische Kontaktierung der Kontaktierungselemente mit den zugehörigen Leiterbahnen des Kunststoffsubstrats kommen Verbindungsabschnitte zum Einsatz, wie dies im Weiteren noch mehr erläutert werden wird.

Nach dem Stand der Technik gemäß der schon vorstehend zitierten EP 3 715 171 B1 stellt das flexible Kunststoffsubstrat der Kontaktierungsplatine einen Hauptzweig einerseits sowie streifenförmige Nebenzweige andererseits bereit. Die streifenförmigen Nebenzweige stellen mit ihrem dem Hauptzweig gegenüberliegenden Endbereich jeweils Kontaktbereiche zur Verfügung, die jeweils die mit den Anschlusspolen des Energiespeichers zusammenwirkenden Kontaktierungselemente tragen. In Abkehr zu dieser Ausgestaltung ist bei der erfindungsgemäßen Ausgestaltung auf streifenförmige Nebenzweige verzichtet. Die Kontaktierungselemente sind vielmehr beabstandet zum Kunststoffsubstrat, d. h. außerhalb desselben ausgebildet und über eine entsprechende elektrische Verbindung direkt an die erste Leiterbahn der Kontaktierungsplatine elektrisch angeschlossen. Die aufgrund der erfindungsgemäß vorgesehenen Heizeinrichtung bevorzugte leiterförmige Ausgestaltung des Kunststoffsubstrats kann mithin in vorteilhafter Weise unverändert bleiben.

Gemäß einem weiteren Merkmal der Erfindung ist vorgesehen, dass eine erste Leiterbahn in einen Anschlusspfad mündet, an den ein Kontaktierungselement elektrisch angeschlossen ist. Der Anschlusspfad dient mithin als elektrische Brücke zwischen einer ersten Leiterbahn und einem Kontaktierungselement. Dabei können an einen Anschlusspfad vorzugsweise auch mehr als nur ein Kontaktierungselement angeschlossen werden. Der Anschlusspfad bietet mithin den Vorteil, einen oder mehrere Kontaktierungselemente in einfacher Weise an eine erste Leiterbahn elektrisch anschließen zu können. Dabei bietet die Verwendung von zwei parallel geschalteten Kontaktierungselementen insbesondere den Vorteil, dass eine Erhöhung der Zuverlässigkeit für die Zellspannungsmessung gegeben ist. Im Übrigen kann aufgrund der Ausgestaltung eines Anschlusspfads auf eine Schweißverbindung verzichtet werden, was die Herstellung vereinfacht. Es ist dann im Montagefall nur noch erforderlich, die Kontaktierungselemente mit den Zellpolen elektrisch zu verbinden, was vorzugsweise durch Verschweißen erfolgt.

Gemäß einem weiteren Merkmal der Erfindung ist für einen elektrischen Anschluss eines Kontaktierungselements an einen Anschlusspfad ein vorzugsweise s-förmig ausgebildeter Verbindungsabschnitt vorgesehen. Ein Kontaktierungselement ist mithin unter Zwischenordnung eines Verbindungsabschnitts an einem Anschlusspfad elektrisch angeschlossen. Dabei bietet ein solcher Verbindungsabschnitt in vorteilhafter Weise die Möglichkeit, das damit zusammenwirkende Kontaktierungselement in Relation zum Kunststoffsubstrat positionieren zu können. Dies unterstützt eine positionsgenaue Ausrichtung der Kontaktierungselemente zwecks elektrischem Anschluss an einen zugehörigen Anschlusspol des Energiespeichermoduls. Zwecks Erhöhung einer Positionsvariabilität ist der Verbindungsabschnitt vorzugsweise s-förmig ausgebildet. Dies ermöglicht sowohl eine Längung als auch eine Abwinklung in Relation zum Kunststoffsubstrat. Etwaige Passungenauigkeiten zwischen der Position der Kontaktierungsplatine auf dem elektrischen Speichermodul einerseits und der Lage der Anschlusspole des Energiespeichermoduls andererseits können so in vorteilhafter Weise ausgeglichen werden. Dies ermöglicht auch, etwaige Herstellungstoleranzen ausgleichen zu können.

Gemäß einem weiteren Merkmal der Erfindung ist vorgesehen, dass der Verbindungsabschnitt und das zugehörige Kontaktierungselement einstückig vorzugsweise aus Nickel ausgebildet und mit dem Anschlusspfad verlötet sind. Gemäß dieser Ausführungsform wird das Kontaktierungselement durch ein sogenanntes Nickel-Pad gebildet, das über den davon einstückig bereitgestellten Verbindungsabschnitt direkt mit dem zugehörigen Anschlusspfad der Kontaktierungsplatine verlötet werden kann. Eine einfache und kostengünstige Herstellung ist so zusätzlich unterstützt.

Weitere Merkmale und Vorteile der Erfindung ergeben sich aus der nachfolgenden Beschreibung anhand der Figuren. Dabei zeigen
- Figur 1: in schematischer Draufsicht von oben die im endmontierten Zustand einem Energiespeichermodul zugewandte Seite einer erfindungsgemäßen Kontaktierungsplatine;
- Figur 2: in schematischer Ausschnittsdarstellung eine von der dem Energiespeichermodul zugewandten Seite der Kontaktierungsplatine bereitgestellte Heizeinrichtung und
- Figur 3: in schematischer Detailansicht die dem Energiespeichermodul im endmontierten Zustand abgewandte Seite der Kontaktierungsplatine, die mit ersten und dritten Leiterbahnen ausgerüstet ist.

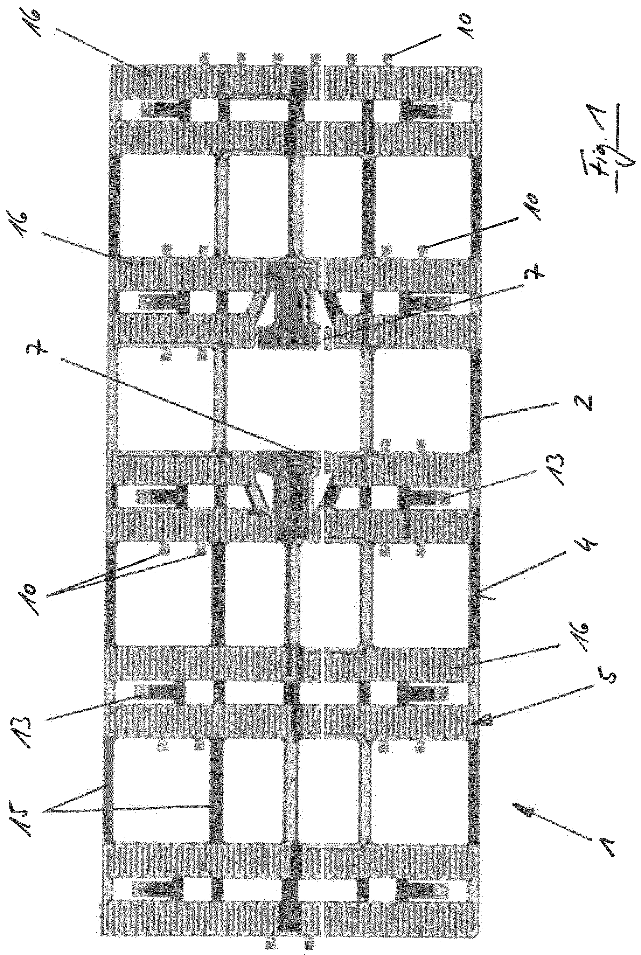

Eine erfindungsgemäße Kontaktierungsplatine 1 ist schematisch in Figur 1 dargestellt.

Die Kontaktierungsplatine 1 verfügt über ein flexibles Kunststoffsubstrat 2, das bspw. als flexible Kunststofffolie ausgebildet ist. Im dargestellten Ausführungsbeispiel ist das Kunststoffsubstrat 2 leiterähnlich ausgebildet und verfügt über Längsabschnitte 15 einerseits und Querabschnitte 16 andererseits.

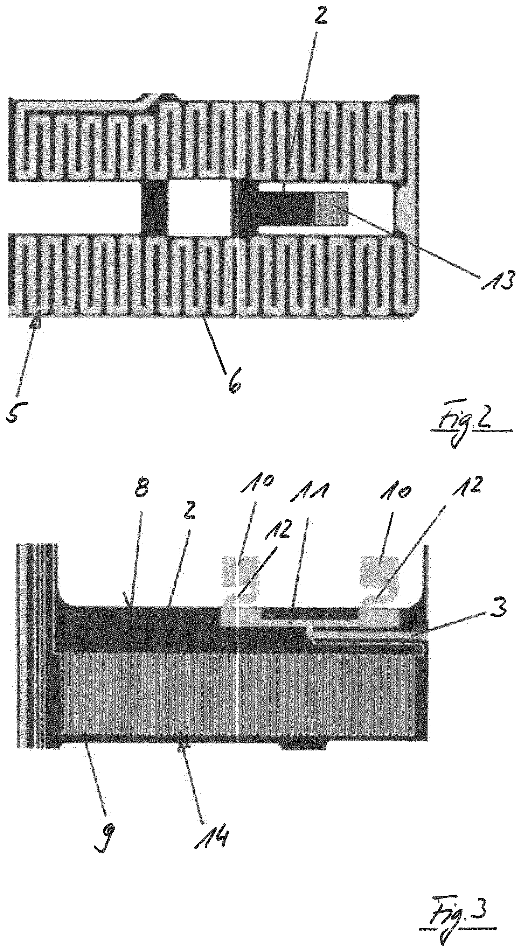

Fig. 1 lässt die einem Energiespeichermodul im endmontierten Zustand zugewandte Seite 4 der Kontaktierungsplatine 1 erkennen. Diese dem Energiespeichermodul im endmontierten Zustand zugewandte Seite 4 der Kunststoffplatine 1 ist erfindungsgemäß mit einer Heizeinrichtung 5 ausgestattet. Dabei weist die Heizeinrichtung 5 eine auf das Kunststoffsubstrat aufgebrachte, vorzugsweise aufgedruckte Leiterbahn 6 auf. Dieser Sachzusammenhang ergibt sich insbesondere aus der Detailansicht nach Figur 2.

Die Leiterbahn 6 der Heizeinrichtung 5 ist zumindest abschnittsweise mäanderförmig verlaufend ausgebildet, wie sich dies ebenfalls insbesondere aus der Darstellung nach Fig. 2 ergibt.

Durch den mäanderförmigen Verlauf der Leiterbahnen 6 sind quasi Heizwiderstände gegeben, die im Bestromungsfall damit zusammenwirkende Zellen des Energiespeichermoduls erwärmen.

Wie sich aus der Darstellung nach Fig. 1 ergibt, ist die Leiterbahn 6 im Bereich der Querabschnitte 16 des Kunststoffsubstrats 2 mäanderförmig verlaufend ausgebildet. Diese Querabschnitte 16 kommen im endmontierten Zustand der Kontaktierungsplatine 1 direkt oberhalb der jeweiligen Zellen des Energiespeichermoduls zu liegen. Es ist so ein unmittelbarer Wärmeübertrag von der Heizeinrichtung 15 auf die zugehörigen Zellen des Energiespeichermoduls sichergestellt.

Wie sich aus einer Zusammenschau der Figuren 1 und 2 ferner ergibt, verfügt die Kontaktierungsplatine 1 des Weiteren über Temperatursensoren 13. Diese wirken im endmontierten Zustand der Kontaktierungsplatine mit den dazugehörigen Zellen des Energiespeichermoduls zusammen und ermöglichen eine Zelltemperaturerfassung. Mittels einer elektronischen Schaltung wird die Heizeinrichtung 5 vorzugsweise in Abhängigkeit der von den Temperatursensoren 13 erfassten Zelltemperaturen ein- bzw. ausgeschaltet.

Die Heizeinrichtung 5 wird vorzugsweise aus der Gesamtspannung des Energiespeichermoduls versorgt, zu welchem Zweck die Leiterbahn 6 der Heizeinrichtung 5 in entsprechende Kontakte einmündet. Über diese Kontakte ist im bestimmungsgemäßen Verwendungsfall eine elektrische Verbindung der Heizeinrichtung 5 mit dem Energiespeichermodul realisiert.

Das flexible Kunststoffsubstrat 2 stellt ferner erste Leiterbahnen 3 für eine elektrische Verbindung einer Sensorplatine mit Anschlusspolen des Energiespeichermoduls bereit. Dabei sind die ersten Leiterbahnen 3 auf der dem Energiespeichermodul im endmontierten Zustand abgewandten Seite 8 des Kunststoffsubstrats 2 ausgebildet, wie dies die Detaildarstellung nach Fig. 3 erkennen lässt. Für eine elektrische Kontaktierung der ersten Leiterbahnen 3 mit einer oder mehreren in den Figuren nicht im Besonderen dargestellten Sensorplatinen sind entsprechende Kontakte 7 vorgesehen, wie sich dies insbesondere aus der Darstellung nach Fig. 1 ergibt.

Anschlusspolseitig stellt die Kontaktierungsplatine 1 Kontaktierungselemente 10 bereit. Diese sind an eine erste Leiterbahn 3 elektrisch angeschlossen. Zu diesem Zweck ist ein Anschlusspfad 11 vorgesehen, der vom Kunststoffsubstrat 2 bereitgestellt ist und in den die erste Leiterbahn 3 elektrisch einmündet. Für einen elektrischen Anschluss eines Kontaktierungselements 10 an den Anschlusspfad 11 ist ein s-förmig ausgebildeter Verbindungsabschnitt 12 vorgesehen. Dabei sind das Kontaktierungselement 10 und der zugehörige Verbindungsabschnitt 11 vorzugsweise einstückig ausgebildet. Als bevorzugtes Material für das Kontaktierungselement 10 und den Verbindungsabschnitt 12 dient Nickel. Zur Verbindung eines Verbindungsabschnitts 12 mit einem Anschlusspfad 11 kann vorzugsweise Verlöten vorgesehen sein.

Die vorzugsweise s-förmige Ausgestaltung des Verbindungsabschnitts 12 erbringt den Vorteil, dass das nicht vom Kunststoffsubstrat 2 getragene Kontaktierungselement 10 in Relation zum Kunststoffsubstrat 2 in seiner Position veränderbar ist. Es können so etwaige Herstellungstoleranzen oder Positionierungstoleranzen ausgeglichen werden, sodass in jedem Fall eine bestimmungsgemäße Kontaktierung eines Kontaktierungselements 10 mit einem Anschlusspol des Energiespeichermoduls sichergestellt ist. Die s-förmige Ausgestaltung des Verbindungsabschnitts 12 dient ferner dazu, im dynamischen Belastungsfall Relativbewegungen zwischen der Kontaktierungsplatine 1 und dem Energiespeichermodul ausgleichen zu können.

Wie sich aus der Darstellung nach Fig. 3 ferner ergibt, ist das Kunststoffsubstrat 2 auf seiner dem Energiespeichermodul im endmontierten Zustand abgewandten Seite 8 mit einer dritten und einen Balancing-Widerstand 14 bereitstellenden dritten Leiterbahn 9 ausgerüstet. Dabei ist die dritte Leiterbahn 9 elektrisch an die erste Leiterbahn 3 und somit auch an die Kontaktierungselemente 10 elektrisch angeschlossen.

Mit der erfindungsgemäßen Kontaktierungsplatine wird eine multifunktionale Kontaktierungsplatine 1 bereitgestellt. Denn die erfindungsgemäße Kontaktierungsplatine 1 beherbergt nicht nur erste Leiterbahnen zur elektrischen Verbindung einer Sensorplatine mit Anschlusspolen des Energiespeichermoduls. Es sind ferner in die Kontaktierungsplatine 1 Balancing-Widerstände 14 sowie eine Heizeinrichtung 5 integriert. Dabei befindet sich die Heizeinrichtung 15 auf der einen Seite des Kunststoffsubstrats 2, nämlich auf der dem Energiespeichermodul im endmontierten Zustand zugewandten Seite 4. Die anderen Leiterbahnen, d. h. die ersten Leiterbahnen 3 sowie die dritten Leiterbahnen 9 sind auf der anderen Seite des Kunststoffsubstrats 2 angeordnet, nämlich auf der dem Energiespeichermodul im endmontierten Zustand abgewandten Seite 8.

### Bezugszeichen

- 1: Kontaktierungsplatine
- 2: Kunststoffsubstrat
- 3: Erste Leiterbahn
- 4: Energiespeichermodul zugewandte Seite
- 5: Heizeinrichtung
- 6: Zweite Leiterbahn
- 7: Kontakte
- 8: Energiespeichermodul abgewandte Seite
- 9: Dritte Leiterbahn
- 10: Kontaktierungselemente
- 11: Anschlusspfad
- 12: Verbindungsabschnitt
- 13: Temperatursensoren
- 14: Balancing-Widerstände
- 15: Längsabschnitt
- 16: Querabschnitt
- 17: erste Großseite
- 18: zweite Großseite

## Patentansprüche

1. Kontaktierungsplatine für ein Energiespeichermodul, insbesondere einen Lithium-Ionen-Akkumulator, mit einem flexiblen Kunststoffsubstrat (2), das erste Leiterbahnen (3) für eine elektrische Verbindung einer Sensorplatine mit Anschlusspolen des Energiespeichermoduls bereitstellt, wobei das Kunststoffsubstrat (2) eine erste Großseite (17) und eine hierzu parallel ausgerichtete, zweite Großseite (18) aufweist, wobei eine der beiden Großseiten (17, 18) mit einer Heizeinrichtung (5) ausgerüstet ist, **dadurch gekennzeichnet, dass** das Kunststoffsubstrat (2) auf seiner dem Energiespeichermodul im endmontierten Zustand abgewandten Seite (8) mit einer dritten und einen Balancing-Widerstand (14) bereitstellenden Leiterbahn (9) ausgerüstet ist.

2. Kontaktierungsplatine nach Anspruch 1, **dadurch gekennzeichnet, dass** die Heizeinrichtung (5) eine auf das Kunststoffsubstrat (2) aufgebrachte, vorzugsweise aufgedruckte zweite Leiterbahn (6) aus Kupfer aufweist.

3. Kontaktierungsplatine nach Anspruch 2, **dadurch gekennzeichnet, dass** die zweite Leiterbahn (6) zumindest abschnittsweise mäanderförmig verlaufend ausgebildet ist.

4. Kontaktierungsplatine nach Anspruch 2 oder 3, **dadurch gekennzeichnet, dass** die zweite Leiterbahn (6) an das Energiespeichermodul elektrisch anschließbar ausgebildet ist.

5. Kontaktierungsplatine nach einem der vorhergehenden Ansprüche, **dadurch gekennzeichnet, dass** die dritte Leiterbahn (9) an die erste Leiterbahn (3) elektrisch angeschlossen ist.

6. Kontaktierungsplatine nach einem der vorhergehenden Ansprüche, **dadurch gekennzeichnet, dass** die erste (17) der beiden Großseiten (17, 18) mit der Heizeinrichtung (5) und die zweite (18) der beiden Großseiten (17, 18) mit der dritten Leiterbahn (9) sowie vorzugsweise auch mit den ersten Leiterbahnen (3) ausgerüstet sind.

7. Kontaktierungsplatine nach einem der vorhergehenden Ansprüche, **dadurch gekennzeichnet, dass** die mit der Heizeinrichtung (5) ausgerichtete Großseite (17) die dem Energiespeichermodul im endmontierten Zustand zugewandte Seite (4) des Kunststoffsubstrats (2) ist.

8. Kontaktierungsplatine nach einem der vorhergehenden Ansprüche, **dadurch gekennzeichnet, dass** die mit der dritten Leiterbahn (9) und/oder den ersten Leiterbahnen (3) ausgerüstete Großseite (18) die dem Energiespeichermodul im endmontierten Zustand abgewandte Seite (8) des Kunststoffsubstrats (2) ist.

9. Kontaktierungsplatine nach einem der vorhergehenden Ansprüche, **gekennzeichnet durch** mit den Anschlusspolen des Energiespeichermoduls zusammenwirkende Kontaktierungselemente (10), die zum Kunststoffsubstrat (2) beabstandet ausgebildet sind.

10. Kontaktierungsplatine nach Anspruch 9, **dadurch gekennzeichnet, dass** eine erste Leiterbahn (3) in einen Anschlusspfad (11) mündet, an den ein Kontaktierungselement (10) elektrisch angeschlossen ist.

11. Kontaktierungsplatine nach Anspruch 9 oder 10, **gekennzeichnet durch** einen vorzugsweise s-förmig ausgebildeten Verbindungsabschnitt (12), unter dessen Zwischenordnung ein Kontaktierungselement (10) an einen Anschlusspfad (11) elektrisch angeschlossen ist.

12. Kontaktierungsplatine nach Anspruch 11, **dadurch gekennzeichnet, dass** der Verbindungsabschnitt (12) und das Kontaktierungselement (10) einstückig vorzugsweise aus Nickel ausgebildet und mit dem Anschlusspfad (11) verlötet ist.

13. Energiespeichermodul, insbesondere Lithium-Ionen-Akkumulator, der eine Mehrzahl von miteinander elektrisch verschalteten Lithium-Ionen-Zellen aufweist, **gekennzeichnet durch** eine Kontaktierungsplatine nach einem der vorhergehenden Ansprüche 1 bis 12.

14. Energiespeichermodul nach Anspruch 13, **dadurch gekennzeichnet, dass** die Kontaktierungsplatine an vom Energiespeichermodul bereitgestellten Polanschlüssen elektrisch angeschlossen ist, wobei die dem Energiespeichermodul zugewandte Großseite (17) des Kunststoffsubstrats (2) die Heizeinrichtung (5) aufweist.

## Claims

1. Contacting board for an energy storage module, in particular a lithium-ion accumulator, comprising a flexible plastic substrate (2) that provides first conductor tracks (3) for an electrical connection of a sensor board to connection poles of the energy storage module, wherein the plastic substrate (2) has a first large side (17) and, aligned parallel thereto, a second large side (18), wherein one of the two large sides (17, 18) is equipped with a heating device (5), **characterized in that** the plastic substrate (2) is equipped, on its side (8) facing away from the energy storage module in the final assembled state, with a third conductor track (9) that provides a balancing resistor (14).

2. Contacting board according to claim 1, **characterized in that** the heating device (5) comprises a second conductor track (6) from copper applied to the plastic substrate (2), preferably printed thereon.

3. Contacting board according to claim 2, **characterized in that** the second conductor track (6) is designed to run in a meandering pattern, at least in sections.

4. Contacting board according to claim 2 or 3, **characterized in that** the second conductor track (6) is designed to be electrically connectible to the energy storage module.

5. Contacting board according to any one of the preceding claims, **characterized in that** the third conductor track (9) is electrically connected to the first conductor track (3).

6. Contacting board according to any one of the preceding claims, **characterised in that** the first (17) of the two large sides (17, 18) is equipped with the heating device (5) and the second (18) of the two large sides (17, 18) is equipped with the third conductor track (9) and, preferably, also with the first conductor tracks (3).

7. Contacting board according to any one of the preceding claims, **characterized in that** the large side (17) aligned with the heating device (5) is the side (4) of the plastic substrate (2) facing the energy storage module in the final assembled state.

8. Contacting board according to any one of the preceding claims, **characterized in that** the large side (18) equipped with the third conductor track (9) and/or the first conductor tracks (3) is the side (8) of the plastic substrate (2) facing away from the energy storage module in the final assembled state.

9. Contacting board according to any one of the preceding claims, **characterized by** contacting elements (10) cooperating with the connection poles of the energy storage module, which contacting elements are designed to be spaced apart from the plastic substrate (2).

10. Contacting board according to claim 9, **characterized in that** a first conductor track (3) leads into a connection path (11) to which a contacting element (10) is electrically connected.

11. Contacting board according to claim 9 or 10, **characterized by** a preferably s-shaped connecting section (12) under the interposition of which a contacting element (10) is electrically connected to a connection path (11).

12. Contacting board according to claim 11, **characterized in that** the connecting section (12) and the contacting element (10) are integrally formed preferably from nickel and are soldered to the connection path (11).

13. Energy storage module, in particular lithium-ion accumulator, comprising a plurality of electrically interconnected lithium-ion cells, **characterized by** a contacting board according to any one of the preceding claims 1 to 12.

14. Energy storage module according to claim 13, **characterized in that** the contacting board is electrically connected to pole connections provided by the energy storage module, wherein the large side (17) of the plastic substrate (2) facing the energy storage module has the heating device (5).

## Revendications

1. Platine de contact pour un module de stockage d'énergie, en particulier un accumulateur lithium-ion, comprenant un substrat en plastique (2) flexible qui comporte des premières pistes conductrices (3) destinées à la connexion électrique d'une platine de capteurs aux bornes de connexion du module de stockage d'énergie, le substrat en plastique (2) présentant un premier grand côté (17) et, aligné parallèlement à celui-ci, un deuxième grand côté (18), l'un des deux grands côtés (17, 18) est équipé d'un dispositif de chauffage (5), **caractérisée en ce que** le substrat en plastique (2) est équipé, sur son côté (8) opposé au module de stockage d'énergie à l'état final assemblé, d'une troisième piste conductrice (9) qui fournit une résistance d'équilibrage (14).

2. Platine de contact selon la revendication 1, **caractérisée en ce que** le dispositif de chauffage (5) comprend une deuxième piste conductrice (6) en cuivre appliquée sur le substrat en plastique (2), de préférence imprimée sur celui-ci.

3. Platine de contact selon la revendication 2, **caractérisée en ce que** la deuxième piste conductrice (6) est conçue pour suivre un tracé sinueux, au moins par sections.

4. Platine de contact selon la revendication 2 ou 3, **caractérisée en ce que** la deuxième piste conductrice (6) est conçue pour être connectable électriquement au module de stockage d'énergie.

5. Platine de contact selon l'une quelconque des revendications précédentes, **caractérisée en ce que** la troisième piste conductrice (9) est connectée électriquement à la première piste conductrice (3).

6. Platine contact selon l'une quelconque des revendications précédentes, **caractérisée en ce que** le premier (17) des deux grands côtés (17, 18) est équipé du dispositif de chauffage (5) et le second (18) des deux grands côtés (17, 18) est équipé de la troisième piste conductrice (9) ainsi que, de préférence, des premières pistes conductrices (3).

7. Platine de contact selon l'une quelconque des revendications précédentes, **caractérisée en ce que** le grand côté (17) aligné avec le dispositif de chauffage (5) est le côté (4) du substrat en plastique (2) faisant face au module de stockage d'énergie à l'état final assemblé.

8. Platine de contact selon l'une quelconque des revendications précédentes, **caractérisée en ce que** le grand côté (18) équipé de la troisième piste conductrice (9) et/ou des premières pistes conductrices (3) est le côté (8) du substrat en plastique (2) tourné à l'opposé du module de stockage d'énergie à l'état assemblé final.

9. Platine de contact selon l'une quelconque des revendications précédentes, **caractérisée par** des éléments de contact (10) coopérant avec les pôles de connexion du module de stockage d'énergie, lesquels éléments de contact sont conçus pour être espacés du substrat en plastique (2).

10. Platine de contact selon la revendication 9, **caractérisée en ce qu'**une première piste conductrice (3) débouche dans un chemin de connexion (11) auquel un élément de contact (10) est connecté électriquement.

11. Platine de contact selon la revendication 9 ou 10, **caractérisée par** une section de connexion (12) de préférence en forme de S, sous l'interposition de laquelle un élément de contact (10) est connecté électriquement à un chemin de connexion (11).

12. Platine de contact selon la revendication 11, **caractérisée en ce que** la section de connexion (12) et l'élément de contact (10) sont formés d'un seul tenant, de préférence en nickel, et sont soudés au chemin de connexion (11).

13. Module de stockage d'énergie, en particulier accumulateur lithium-ion, comprenant une pluralité de cellules lithium-ion interconnectées électriquement, **caractérisé par** une platine de contact selon l'une quelconque des revendications 1 à 12 précédentes.

14. Module de stockage d'énergie selon la revendication 13, **caractérisé en ce que** la platine de contact est connectée électriquement à des connexions de pôles prévues par le module de stockage d'énergie, dans lequel le grand côté (17) du substrat en plastique (2) faisant face au module de stockage d'énergie comporte le dispositif de chauffage (5).
